# EUROPEAN PATENT SPECIFICATION

(11) **EP 1 751 329 B1**
(45) Date of publication and mention of the grant of the patent: **09.01.2008**
(21) Application number: 05741354.4
(22) Date of filing: 13.05.2005
(51) Int. Cl.: C30B 25/02, C30B 25/20, C30B 29/36, C23C 16/32

(54) **METHOD OF SIC SINGLE CRYSTAL GROWTH AND SIC SINGLE CRYSTAL**
VERFAHREN ZUM ZIEHEN VON SIC-EINKRISTALLEN UND SIC-EINKRISTALL
PROCEDE DE TIRAGE DE MONOCRISTAL SIC ET MONOCRISTAL SIC

(30) Priority: 14.05.2004 JP 2004145179
(43) Date of publication of application: 14.02.2007
(73) Proprietor: TOYOTA JIDOSHA KABUSHIKI KAISHA, Toyota-shi, Aichi-ken, 471-8571 (JP); Sixon Ltd., Kyoto-shi, Kyoto 6158686 (JP)
(72) Inventor: KIMOTO, Tsunenobu;, ku, Kyoto-shi, Kyoto; 6128031 (JP); SHIOMI, Hiromu;, to-shi, Kyoto; 6158686 (JP); SAITOH, Hiroaki; c/o TOYOTA JIDOSHA KABUSHIKI KAIS, Aichi; 4718571 (JP)
(74) Representative: May, Mark Andrew
(86) International application number: PCT/JP2005/009200
(87) International publication number: WO 2005/111277

(56) References cited:
- EP-A- 1 249 521
- EP-A- 1 306 890
- WO-A-03/085175
- US-A- 5 958 132

## Description

### TECHNICAL FIELD

The present invention relates to a method of epitaxial growth of an SiC single crystal, in particular a 4H-SiC single crystal, on an SiC single crystal substrate, in particular a 4H-SiC single crystal substrate.

### BACKGROUND ART

SiC has a larger energy band gap compared with Si, so various technologies for production of high grade SiC single crystal suitable as a semiconductor material etc. has been proposed in Japanese Unexamined Patent Publication (Kokai) No. 2003-300797, Japanese Unexamined Patent Publication (Kokai) No. 2003-300796, Japanese Unexamined Patent Publication (Kokai) No. 2003-342099, Japanese Unexamined Patent Publication (Kokai) No. 2001-181095, Japanese Unexamined Patent Publication (Kokai) No. 10-17399, etc.

However, the above technologies had the following problems:
(1) Crystal defects degrading the semiconductor device properties (stacking faults, triangular-defects, and other surface defects) easily occurred.
(2) The rate of crystal growth was slow.
(3) The flatness of the epitaxial crystal growth plane (surface morphology) was poor

In particular, prevention of the surface defects of the above (1) is a major premise for practical use as a semiconductor material.

As has been known in the past, if making the SiC (0001) plane (bottom plane of hexagonal crystal) the epitaxial growth plane, SiC crystals (polygonal) with different crystal structures will easily become mixed in the growth plane and high quality crystal cannot be obtained.

Therefore, step flow growth has been performed making the growth plane an angle inclined by several degrees from the (0001) plane (off-angle). However, even if adopting this method, it was extremely difficult to completely avoid the occurrence of defects critical to the device properties such as triangular defects or carrot defects (device killers) and achieve stable epitaxial growth.

The reason for this is believed to be that in step flow growth, the crystal growth proceeds in steps in the lateral direction. With substrates with small off-angles, however, the terrace area is large, so starting points of defects easily arise on the terrace surfaces and the defects grown from those starting points are taken into the epitaxial growth layer. Further, pinholes due to large spiral dislocations called "micropipes" extending in the <0001> axial direction are also passed on to the growth layer.

As opposed to this, the practice has also been to make the (11-20) plane the growth plane. While the occurrence of micropipes can be avoided, a large number of stacking faults end up being included. This becomes a cause for deterioration of the device properties.

To solve this problem, Japanese Unexamined Patent Publication (Kokai) No. 2003-300797 discloses to make a plane inclined from the (11-20) plane by an off-angle of at least 3 degrees to not more than 60 degrees in any direction in the range of -45 degrees to 45 degrees in the <1-100> axial direction centered about the <0001> axis the epitaxial thin film growth plane. This improves the growth rate of the SiC single crystal, but has the problem that the influx of impurities cannot be reduced.

In particular, a method of crystal growth solving the above problems has been sought for 4H-SiC single crystal, the crystal polyhedron most suitable as a semiconductor material from the viewpoint of the device properties.

### DISCLOSURE OF THE INVENTION

An object of the present invention is to provide a method of epitaxial growth of a 4H-SiC single crystal enabling growth of an SiC single crystal with low defects and low impurities able to be used for a semiconductor material at a practical growth rate and a 4H-SiC single crystal obtained by the same.

To achieve this object, according to a first aspect of the invention, there is provided a method of growth of an SiC single crystal comprising growing a 4H-SiC single crystal on a 4H-SiC single crystal substrate by epitaxial growth while inclining an epitaxial growth plane of the substrate from a (0001) plane of the 4H-SiC single crystal by an off-angle of at least 12 degrees and less than 18 degrees in a <11-20> axial direction.

Preferably, the off-angle is at least 12 degrees and not more than 25 degrees.

Alternatively, the off-angle is at least 12 degrees and not more than 18 degrees.

According to a second aspect of the invention, there is provided an SiC single crystal grown by a method of the present invention.

### BRIEF DESCRIPTION OF THE DRAWINGS

These and other objects and features of the present invention will become clearer from the following description of the preferred embodiments given with reference to the attached drawings, wherein:
FIG. 1 is a view of the crystal structure showing the off-angle defined in the present invention in an SiC hexagonal crystal;
FIG. 2 is a graph showing the growth rate of SiC single crystal obtained by epitaxial growth while changing the off-angle and C/Si ratio in various ways with respect to the C/Si ratio; any
FIG. 3 is a graph showing the concentration of impurities of SiC single crystal obtained by epitaxial growth while changing the off-angle and C/Si ratio in various ways with respect to the C/Si ratio.

### BEST MODE FOR CARRYING OUT THE INVENTION

Preferred embodiments of the present invention will be described in detail below while referring to the attached figures.

As explained above, according to a first aspect of the invention, there is provided a method of growth of an SiC single crystal comprising growing a 4H-SiC single crystal on a 4H-SiC single crystal substrate by epitaxial growth while inclining an epitaxial growth plane of the substrate from a (0001) plane of the 4H-SiC single crystal by an off-angle of at least 12 degrees and less than 30 degrees in a <11-20> axial direction.

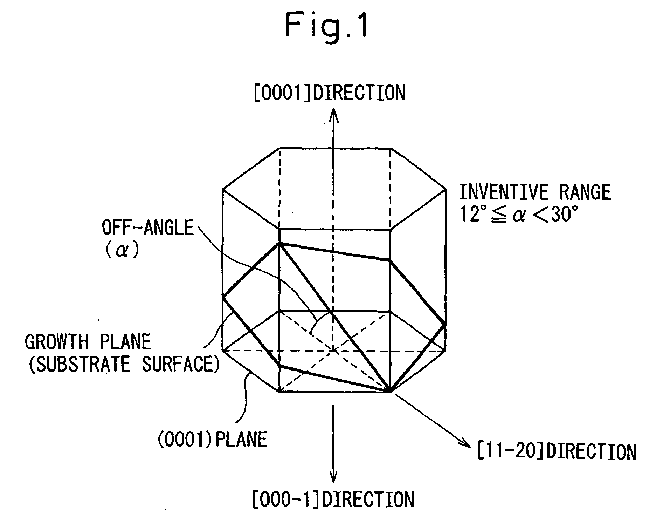

FIG. 1 shows the epitaxial growth plane defined in the present invention. The figure shows the hexagonal crystal structure of a SiC single crystal. The substrate plane, that is, the growth plane, is inclined from the bottom plane of the hexagonal crystal, that is, the (0001) plane, by exactly an off-angle in the <11-20> axial direction.

The off-angle is preferably at least 12 degrees and not more than 25 degrees, most preferably at least 12 degrees and not more than 18 degrees.

According to the present invention, an SiC single crystal grown by the above method is also provided.

The inventors completed the present invention based on the novel discovery that by using a substrate having a plane inclined from the (0001) plane of a 4H-SiC single crystal by an off-angle of at least 12 degrees and less than 30 degrees in the <11-20> axial direction as the epitaxial growth plane, it is possible to grow a low defect, low impurity 4H-SiC single crystal at a practical growth rate.

In the past, as disclosed for example in Japanese Unexamined Patent Publication (Kokai) No. 2003-300797, the practice had been for epitaxial growth on a substrate using as the growth plane a plane inclined from the 4H-SiC single crystal (0001) plane by about 8 degrees in the <11-20> axial direction. In the case of a (0001) slightly inclined plane with an off-angle of 1 degree to 10 degrees, the growth plane was formed as a step and {0001} terrace, so surface roughness called "step-bunching" easily occurred at the growth layer. Further, the growth plane was easily affected by abnormalities on the terrace impurities and particles.

As opposed to this, according to the method of the present invention, the growth rate is improved and simultaneously an extremely flat growth layer can be obtained without roughening of the epitaxial growth surface. A growth plane with an off-angle of 12 degrees or more is not a step and {0001} terrace, but a specific plane determined by that off-angle. In this case, there is no mixture with different polytypes even if two-dimensional nucleus formation occurred at the growth surface. Further, since this is two-dimensional growth, no triangular-defects occur either.

The triangular-defects which easily occurred at a growth plane with an off-angle of 4 to 8 degrees are substantially eliminated according to the present invention by making the off-angle at least 12 to less than 30 degrees. This is because if the off-angle is made larger, the terrace width of the crystal growth plane becomes smaller and the starting points for occurrence of defects on the terrace are greatly reduced. Further, since the density of the free bonding arms at the crystal surface differs from that at the (0001) plane, the efficiency of influx of impurities also changes. Specifically, the influx of N atoms is suppressed and fabrication of high purity crystal becomes easy.

By adopting the off-angle of the present invention, an extremely high quality epitaxial growth layer with low residual impurities (donors and acceptors) compared with conventional substrates with an off-angle of about 8 degrees can be obtained. In particular, when the off-angle is about 15 degrees, the highest purity crystal is obtained.

In the present invention, by making the C/Si ratio (ratio of mixture of SiC material gases such as silane gas and propane gas), one of the conditions for epitaxial crystal growth, small, the micropipes present in the substrate are dissociated. This is observed even in conventional 8 degree off-angle substrates, but by making the off-angle large, the energy required for micropipes to pass through the <0001> axial direction becomes higher (dislocation line becomes longer), the progression of micropipes to the <0001> axial direction is obstructed, and the dissociation of micropipes is promoted compared with the conventional 8 degree off-angle substrates.

By making the off-angle at least 12 degrees, the effects of reduction of the defects and reduction of the impurities are obtained, but if the off-angle is made too large, stacking faults will easily occur and the concentration of residual impurities will conversely increase, so the off-angle was limited to less than 30 degrees.

### Examples

### Example 1

A substrate having a plane inclined from the (0001) plane of a 4H-SiC single crystal by an off-angle of 15 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 15 degrees with respect to the (0001) axial direction to prepare a wafer and polishing the wafer surface. The thickness of the substrate was about 380 µm.

The epitaxial growth was carried out by chemical vapor deposition (CVD). The system used was a horizontal hotwall CVD system. The substrate was loaded into a graphite susceptor surrounded by a graphite insulator, then the reactor was evacuated to about 1 x 10⁴ Pa or less.

Next, a carrier gas comprised of 8 slm of hydrogen gas and 0.8 slm of argon gas was introduced into the reactor and high frequency induction heating was used to heat the graphite susceptor. The heated graphite susceptor heated the substrate. When the substrate temperature reached 1350°C to 1550°C, the substrate was held there for about 1 minute to 30 minutes. Due to this, the substrate surface was etched by the hydrogen gas and the residual impurities on the surface were removed and the surface flattened.

Next, a material gas of silane gas and propane gas was introduced into the reactor and an SiC single crystal was epitaxially grown. The growth conditions were a silane gas flow rate of 2 sccm, a propane gas flow rate of 1 sccm (C/Si ratio equivalent to 1.5), a substrate temperature of 1550°C, and a pressure of 80 Torr. The crystal was grown under these conditions for about 2 hours. As a result, an SiC single crystal epitaxial growth layer of a thickness of 8 µm was obtained. The growth rate was 4 µm/h.

The surface roughness of the obtained epitaxial growth layer was measured by an atomic force microscope (AFM). As a result, the flatness was an extremely high 0.1 nm in terms of RMS. The surface roughness of the substrate before growth was 0.2 nm in terms of RMS, so the surface of the growth layer was improved in flatness compared with the substrate surface.

The surface of the growth layer was observed by a Normarski optical microscope. As a result, no triangular defects or other device killers could be recognized.

Further, the epitaxial substrate was formed with nickel electrodes by vacuum vapor deposition to form Schottky electrodes. These Schottky electrodes were used to measure the concentration of impurities in the epitaxial growth layer by the capacitance-voltage measurement method. As a result, the donor density was 3 x 10¹³ cm⁻³ or an extremely small influx of impurities and an extremely high quality.

### Example 2

The same substrate as in Example 1 and the same CVD system and conditions were used for epitaxial growth of 4H-SiC single crystal. However, in the growth conditions, the flow rate of propane gas was changed to 0.67 sccm and the C/Si ratio was made 1.0 or so. As a result, the grown thickness became 8.8 µm and the growth rate was improved to 4.4 µm/h.

The surface of the growth layer was observed by a Normarski optical microscope. As a result, like in Example 1, no triangular-defects could be recognized.

The surface roughness was 0.1 nm in terms of RMS.

### Example 3

The same substrate as in Example 1 and the same CVD system and conditions were used for epitaxial growth of 4H-SiC single crystal. However, in the growth conditions, the flow rate of propane gas was changed to 0.33 sccm and the C/Si ratio was made 0.5 or so. As a result, the grown thickness became 3.5 µm and the growth rate became 1.75 µm/h.

The surface of the growth layer was observed by a Normarski optical microscope. As a result, like in Example 1, no triangular-defects could be recognized. Further, it was confirmed that the micropipe which had been present in the substrate dissociated and disappeared at the epitaxial growth layer.

The surface roughness was 0.1 nm in terms of RMS.

### Example 4

A substrate having a plane inclined from the (0001) plane of a 4H-SiC single crystal by an off-angle of 25 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 25 degrees with respect to the (0001) axial direction to prepare a wafer and polishing the wafer surface. The thickness of the substrate was about 380 µm.

Using this substrate and the same CVD system and conditions, a 4H-SiC single crystal was epitaxially grown. The growth conditions were the same as in Example 1. As a result, the grown thickness became 8.6 µm and the growth rate was improved to 4.3 µm/h.

The surface of the growth layer was observed by a Normarski optical microscope. As a result, like in Example 1, no triangular-defects could be recognized.

### Example 5

The same substrate as in Example 4 and the same CVD system and conditions were used for epitaxial growth of 4H-SiC single crystal. However, in the growth conditions, the flow rate of propane gas was changed to 0.67 sccm and the C/Si ratio was made 1.0 or so. As a result, the grown thickness became 9.4 µm and the growth rate was improved to 4.7 µm/h.

The surface of the growth layer was observed by a Normarski optical microscope. As a result, like in Example 1, no triangular-defects could be recognized.

### Comparative Example 1

A substrate having a plane inclined from the (0001) plane of a 4H-SiC single crystal by an off-angle of 8 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 8 degrees with respect to the (0001) axial direction to prepare a wafer and polishing the wafer surface. The thickness of the substrate was about 380 µm.

Using this substrate and the same CVD system and conditions as in the examples of the invention, a 4H-SiC single crystal was epitaxially grown.

Among the growth conditions, the propane gas flow rate was made 0.67 sccm and the C/Si ratio was made 1.0 or so. As a result, the grown thickness became 6.7 µm and the growth rate was 3.35 µm/h.

The surface of the growth layer was observed by a Normarski optical microscope. As a result, the existence of triangular-defects was confirmed.

### Comparative Example 2

A substrate having a plane inclined from the (0001) plane of a 4H-SiC single crystal by an off-angle of 4 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 4 degrees with respect to the (0001) axial direction to prepare a wafer and polishing the wafer surface. The thickness of the substrate was about 380 µm.

Using this substrate and the same CVD system and conditions as in the examples of the invention, a 4H-SiC single crystal was epitaxially grown.

Among the growth conditions, the propane gas flow rate was made 0.67 sccm and the C/Si ratio was made 1.0 or so. As a result, the grown thickness became 8.4 µm and the growth rate was 4.2 µm/h.

The surface of the growth layer was observed by a Normarski optical microscope. As a result, the existence of triangular-defects was confirmed.

The surface roughness was measured by an atomic force microscope (AFM). As a result, it was found to be 1.4 nm in terms of RMS. Since the surface roughness of the substrate was 0.1 to 0.2 nm in RMS, the surface of the growth layer seriously got worse in flatness from even the substrate surface.

### Comparative Example 3

A substrate having a plane inclined from the (0001) plane of a 4H-SiC single crystal by an off-angle of 30 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 30 degrees with respect to the (0001) axial direction to prepare a wafer and polishing the wafer surface. The thickness of the substrate was about 380 µm.

Using this substrate and the same CVD system and conditions as in the examples of the invention, a 4H-SiC single crystal was epitaxially grown.

Among the growth conditions, the propane gas flow rate was made 0.67 sccm and the C/Si ratio was made 1.0 or so. As a result, the grown thickness became 9.8 µm and the growth rate was 4.9 µm/h.

The surface of the growth layer was observed by a Normarski optical microscope. As a result, the existence of defects was confirmed.

The surface roughness was measured by an AFM. As a result, it was found to be an extremely flat 0.1 nm in terms of RMS.

### Comparative Example 4

A substrate having a plane inclined from the (0001) plane of a 4H-SiC single crystal by an off-angle of 45 degrees in the <11-20> axial direction as the epitaxial growth plane was prepared. This substrate obtained by slicing a 4H-SiC single crystal grown by sublimation as a seed crystal using the (0001) plane as the growth plane at a plane inclined by 45 degrees with respect to the (0001) axial direction to prepare a wafer and polishing the wafer surface. The thickness of the substrate was about 380 µm.

Using this substrate and the same CVD system and conditions as in the examples of the invention, a 4H-SiC single crystal was epitaxially grown.

Among the growth conditions, the propane gas flow rate was made 0.67 sccm and the C/Si ratio was made 1.0 or so. As a result, the grown thickness became 12 µm and the growth rate was 6 µm/h.

The surface of the growth layer was observed by a Normarski optical microscope. As a result, the existence of defects was confirmed.

The surface roughness was measured by an AFM. As a result, it was found to be an extremely flat 0.1 nm in terms of RMS.

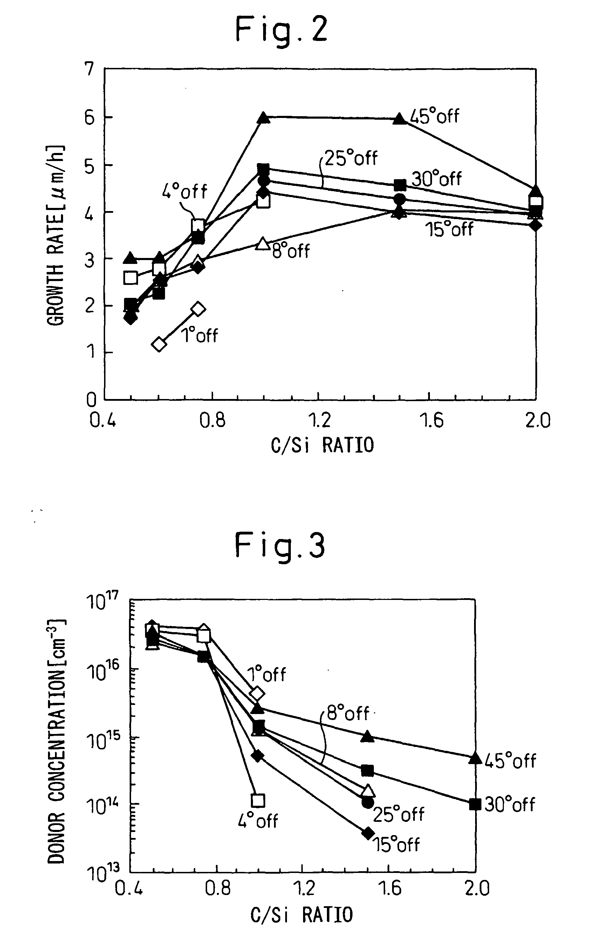

In the above explained Examples 1 to 5 and Comparative Examples 1 to 4, epitaxial growth was conducted while changing the off-angle in various ways from 1 degree to 45 degrees and the C/Si ratio in the range of 0.5 to 2.0. The changes in the growth rate and impurity concentrations with respect to the C/Si ratios of the obtained 4H-SiC single crystal epitaxial growth layers are shown in FIG. 2 and FIG. 3. It is learned that by making the off-angle at least 12 degrees and less than 30 degrees as in the present invention, the growth rate is improved and simultaneously the impurity concentration is reduced.

### INDUSTRIAL APPLICABILITY

According to the present invention, there are provided a method of epitaxial growth of a 4H-SiC single crystal enabling growth of an SiC single crystal with low defects and low impurities able to be used for a semiconductor material at a practical growth rate and a 4H-SiC single crystal obtained by the same.

## Claims

1. A method of growth of an SiC single crystal comprising growing a 4H-SiC single crystal on a 4H-SiC single crystal substrate by epitaxial growth while inclining an epitaxial growth plane of said substrate from a (0001) plane of the 4H-SiC single crystal by an off-angle of at least 12 degrees and not more than 18 degrees in an <11-20> axial direction.

## Patentansprüche

1. Verfahren zum Züchten eines SiC-Einkristalls, umfassend das Züchten eines 4H-SiC-Einkristalls auf einem 4H-SiC-Einkristallsubstrat durch epitaxiales Wachstum, wobei eine epitaxiale Wachstumsebene des Substrats von einer (0001)-Ebene des 4H-SiC-Einkristalls um einen Abweichungswinkel von mindestens 12 Grad und höchstens 18 Grad in einer <11-20>-Achsenrichtung geneigt ist.

## Revendications

1. Procédé de croissance d'un monocristal de SiC comprenant de mettre en croissance un monocristal de 4H-SiC sur un substrat de monocristal de 4H-SiC par croissance épitaxiale tout en inclinant un plan de croissance épitaxiale dudit substrat à partir d'un plan (0001) du monocristal de 4H-SiC d'un angle de décalage d'au moins 12 degrés et de pas plus de 18 degrés dans une direction axiale <11-20>.
